# EUROPEAN PATENT APPLICATION

(11) **EP 1 256 976 A2**
(43) Date of publication of application: **13.11.2002**
(21) Application number: 02009958.6
(22) Date of filing: 03.05.2002
(51) Int. Cl.: H01L 21/02

(54) **Method for producing semiconductor device**

(30) Priority: 08.05.2001 JP 2001137456
(71) Applicant: NEC CORPORATION, Tokyo (JP)
(72) Inventor: Miyasaka, Yoichi, c/oNEC Corporation, Tokyo (JP)
(74) Representative: Glawe, Delfs, Moll & Partner

(57) **Abstract**

To provide a method for producing a semiconductor device employing a ceramic capacitor which realizes a low voltage operation. The method for producing a semiconductor device having a dielectric capacitor includes a first step of forming a lower electrode (13), a second step of forming a polycrystalline dielectric thin film (14) having roughness on its surface on the lower electrode, a third step of rapidly heating a surface layer portion of the dielectric thin film of a predetermined film thickness to melting and quenching the portion to planarize the surface of the thin film, and a fourth step of forming an upper electrode (15) on the dielectric thin film.

## Description

### FIELD OF THE INVENTION

This invention relates to a method for producing a semiconductor device having a dielectric capacitor. More particularly, it relates to a method for producing a semiconductor device that can operate at a low supply voltage.

### BACKGROUND OF THE INVENTION

In recent years, researches and developments in a ferroelectric memory or in a dynamic random access memory (DRAM) exploiting a high relative dielectric constant material are going on briskly. In the ferroelectric memory or the DRAM, there is provided a switching transistor and information is stored in a capacitor which is connected to one diffusion layer of the switching transistor and composes a memory cell.

A ferroelectric capacitor provided in a ferroelectric memory, in which a ferroelectric thin film, such as PZT (PbZrₓTi₁₋ₓO₃), PLZT (Pb₁₋ _{y}La_{y}ZrₓTi₁₋ₓO₃), SBT (SrBi₂Ta₂O₉) or the like, is used as a capacitor insulating film, is capable of storing the non-volatile information based on polarization of the ferroelectric material.

On the other hand, a high dielectric constant capacitor provided in a DRAM, in which a high dielectric constant thin film, such as BST (BaₓSr₁₋ₓTiₒ) or the like, is used as a capacitor insulating film, can be reduced in effective film thickness with increase in capacity.

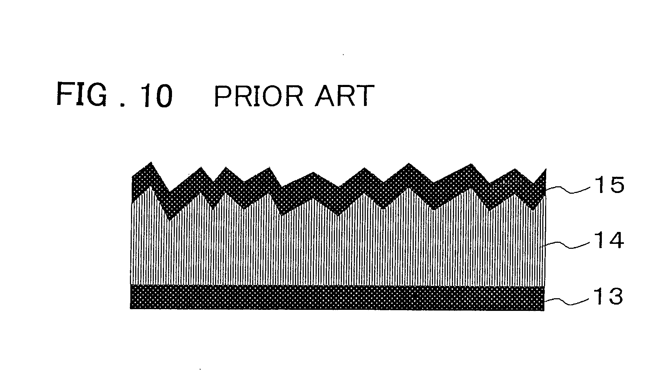

A conventional ferroelectric memory includes a ferroelectric capacitor, which is made up of a lower electrode 13, a ferroelectric thin film 14 and an upper electrode 15, formed in this order, as shown in Fig. 10, above a switching transistor (not shown), via inter-layer insulating film(not shown). The lower electrode is connected to one of the diffusion layers of the switching transistor via a plug filled into the contact hole which is formed in the inter-layer insulating film. It is noted that the ferroelectric thin film is formed on the lower electrode by a film-deposition method, such as a sputtering method, a sol/gel method or a CVD method, and is made to have the perovskite crystal structure on annealing at a preset temperature. The dielectric thin film, thus formed, has a polycrystalline structure and there is roughness present on the thin film surface.

### SUMMARY OF THE DISCLOSURE

However, the roughness on the surface of a ferroelectric thin film, with the progress of miniaturization of the memory cell and the increase in its density may be the cause of the following inconveniences.

For maintaining a capacitor in keeping pace with miniaturization and high density of the memory cell, it is meritorious to reduce the thickness of the ferroelectric thin film. However, in order to obtain an optimum ferroelectric characteristic, such as a polarization inversion characteristic, it is retained to be necessary that the crystal grain size be not less than approximately 50 nm, and hence there inevitably exist surface roughness of a size close to the crystal grain size on the surface of the ferroelectric thin film. Consequently, there is raised a problem that, if the film thickness is reduced, the concentration of electric filed (leakage current) tends to be produced in a film thickness thin portion in the recess in the film surface.

This concentration of the electric field deteriorates insulating properties of the ferroelectric thin film or the polarization inversion characteristic and hence obstructs reduction in film thickness of the ferroelectric film to render the realization of the low voltage operation impossible.

On the other hand, it may be contemplated to execute planarization of the roughness on the ferroelectric thin film surface for the realization of the low voltage operation. However, if this planarization is to be achieved by re-flow processing, this approach is not desirable because there is some possibility that an electrode or metal wiring located below the thin film tend to be damaged by high temperature in the re-flow processing.

In the JP Patent Kokai JP-A-2000-81642, there has been disclosed a technology in which a hydrogen-containing amorphous semiconductor film is irradiated with a laser a plural number of times to form a crystalline semiconductor presenting surface roughness to a lesser extent and also having larger crystal grain size. That is, the laser irradiation is carried out in order to convert the amorphous silicon to polycrystalline silicon. Although this technology may suffice for silicon, it cannot be applied for the case with the ferroelectric material of the perovskite structure.

In e.g., Appl. Phys. Lett. 66(19), 8 May 1995, there has been disclosed a technology which consists in irradiating the amorphous PZT film with a KrF excimer laser to crystallize its surface.

In the JP Patent Kokai JP-A-10-200120, there has also been disclosed a technology in which surface roughness produced on the poly-silicon film on laser-annealing the amorphous silicon film are planarized by the CMP(chemical mechanical polishing) processing. However, even if the surface presenting roughness is planarized by the CMP processing, it is difficult to realize a uniform and thin film thickness.

Accordingly, it is an object of the present invention to provide a method for producing a semiconductor device employing a dielectric capacitor advantageously suited for realizing miniaturization and high density of the memory cell.

Another object of the present invention is to provide a method for producing a semiconductor device employing a dielectric capacitor which realizes the low voltage operation.

A further object of the present invention is to provide a method for producing a dielectric capacitor which doe not damage metal wiring layer and the like.

A further object of the present invention of the present invention is to provide a method for producing a semiconductor device employing the dielectric capacitor having a satisfactory transistor characteristic.

The above and other objects of the invention are satisfied, at least in part, in accordance with one aspect of the present invention, by providing a method for producing a semiconductor device having a dielectric capacitor, comprising: a first step of forming a lower electrode(13); a second step of forming a polycrystalline dielectric thin film (14) having roughness on its surface on the lower electrode; a third step of rapidly heating a surface layer portion of a predetermined film thickness in the dielectric thin film to melting and quenching the portion to flatten out the surface of the thin film; and a fourth step of forming an upper electrode(15) on the dielectric thin film.

In the method for producing the semiconductor device in accordance with the present invention, the maximum height of the surface roughness of the dielectric thin film, formed in the second step, is preferably not less than 50 nm. It is because a capacitor may then be formed in which the dielectric thin film has a crystal grain size not larger than 50 nm and which exhibits an optimum polarization hysteresis characteristic.

In the method for producing the semiconductor device, in accordance with the present invention, the thickness to the apex of the maximum projection from the bottom surface of the lower electrode of the dielectric thin film formed by the second step is preferably not less than 200 nm, because the crystal grain size of a constant value can then be maintained even after flattening out processing.

Also, in the method for producing the semiconductor device, in accordance with the present invention, the aspect ratio of crystal grains of the dielectric thin film, formed by the above-described second step, is preferably not larger than 200 nm, because this guarantees a certain constant crystal grain size even after flattening processing.

In accordance with a second aspect of the present invention, there is provided a method for producing a semiconductor device having a dielectric capacitor, comprising: a first step of forming a lower electrode; a second step of forming, on the lower electrode, a polycrystalline dielectric thin film containing crystals of a preset grain size; a third step of forming a processed film obtained on amorphizing or crystallizing a surface layer portion of a preset film thickness in the dielectric thin film, in such a manner as to maintain the crystal grain size of a lower surface portion thereof at such a value as to retain a desired characteristic of the dielectric material; and a fourth step of forming an upper electrode on the dielectric thin film. It is because crystallization or amorphizing of the crystals is thought to be among the characteristics proper to the dielectric material of he perovskite crystal structure.

In the method for producing the semiconductor device, in accordance with the present invention, the desired characteristic of the dielectric is a polarization hysteresis characteristic.

In the method for producing the semiconductor device, in accordance with the present invention, a fifth step of etching the surface layer portion, rapidly heated and subsequently quenched, or amorphized, or crystallized, to a flat surface, is preferably provided between the third and fourth steps. It is because this demonstrates desirable properties inherently owned by a dielectric material.

In the method for producing the semiconductor device, in accordance with the present invention, a sixth step of annealing the surface layer portion of the as-etched dielectric thin film is preferably provided because this repairs damages done on etching to the dielectric thin film surface.

In the method for producing the semiconductor device, in accordance with the present invention, a plane surface on the polycrystalline dielectric thin film is preferably exposed by the above fifth step because this demonstrates optimum properties inherently owned by the dielectric material.

In the method for producing the semiconductor device, in accordance with the present invention, the dielectric thin film in the second step preferably has a crystal grain size not less than 50 nm because this achieves optimum dielectric characteristics.

In the method for producing the semiconductor device, in accordance with the present invention, the dielectric thin film in the second step is preferably formed at a temperature not higher than 500°C by chemical vapor deposition because this does not damage e.g., the metal wiring layers.

In the method for producing the semiconductor device, in accordance with the present invention, the third and sixth steps are desirably carried out by irradiating the dielectric thin film with excimer laser, which excimer laser is preferably XeCl excimer laser. It is because this makes amorphous or crystallize the surface layer portion to a grain size smaller than the crystal grain size, with a preset film thickness, as well as to planarize the surface.

In the method for producing the semiconductor device, in accordance with the present invention, the energy density of the excimer laser in the aforementioned sixth step is desirably lower than that in the third step. The energy density of the excimer laser in the aforementioned third step is desirably 160 to 200 mJ/cm², while that in the aforementioned sixth step is desirably 140 to 160 mJ/cm². It is because this flattens the thin film surface and suppresses the film thickness of the polycrystalline or amorphous layer of a small grain size while lessening the deterioration of polarization hysteresis characteristics.

In the method for producing the semiconductor device, in accordance with the present invention, the dielectric thin film is preferably formed of a dielectric material of the perovskite crystal structure, more preferably a ferroelectric material or a high dielectric constant material, and most preferably PZT.

In the method for producing the semiconductor device, in accordance with the present invention, the etching is preferably plasma etching because it is superior in its machining accuracy.

In the method for producing the semiconductor device, in accordance with the present invention, a step of selectively forming at least one metal wiring layer is preferably provided before forming the dielectric capacitor. It is because no damage is done to the metal wiring even if the metal wiring is formed below the capacitor according to the present invention.

Still other objects and advantages of the present invention will become readily apparent to those skilled in this art from the following detailed description in conjunction with the accompanying drawings wherein only the preferred embodiments of the invention are shown and described, simply by way of illustration of the best mode contemplated of carrying out this invention. As will be realized, the invention is capable of other and different embodiments, and its several details are capable of modifications in various obvious respects, all without departing from the invention. Accordingly, the drawing and description are to be regarded as illustrative in nature, and not as restrictive.

### BRIEF DESCRIPTION OF THE DRAWINGS

Fig.1 is a schematic partial cross-sectional view showing the structure of a semiconductor device according to a first embodiment of the present invention.
Fig.2 is partial circuit diagram of the semiconductor device according to a first embodiment of the present invention.
Figs. 3A to 3D are schematic cross-sectional views showing the method for producing a semiconductor device according to a first embodiment of the present invention, step-by-step.
Figs. 4E and 4F, continuing to Fig.3D, are schematic cross-sectional views showing the method for producing a semiconductor device according to a first embodiment of the present invention.
Figs. 5A to 5 C are schematic cross-sectional views showing the method for producing a dielectric capacitor of the semiconductor device according to the first embodiment of the present invention, step-by-step.
Fig.6 is an electron microscope photo of the cross-section, following the deposition of a dielectric thin film, of the semiconductor device according to the first embodiment of the present invention.
Fig.7 is an electron microscope photo of the cross-section, following laser irradiation, of a dielectric thin film of the semiconductor device according to the first embodiment of the present invention.
Figs. 8A to 8D are schematic cross-sectional views showing the method for producing a dielectric capacitor of a semiconductor device of the second embodiment of the present invention, step-by-step.
Figs. 9A to 9E are cross-sectional views showing the method for producing a dielectric capacitor of a semiconductor device of the third embodiment of the present invention, step-by-step.
Fig.10 is a schematic cross-sectional view showing a conventional dielectric capacitor.

### PREFERRED EMBODIMENTS OF THE INVENTION

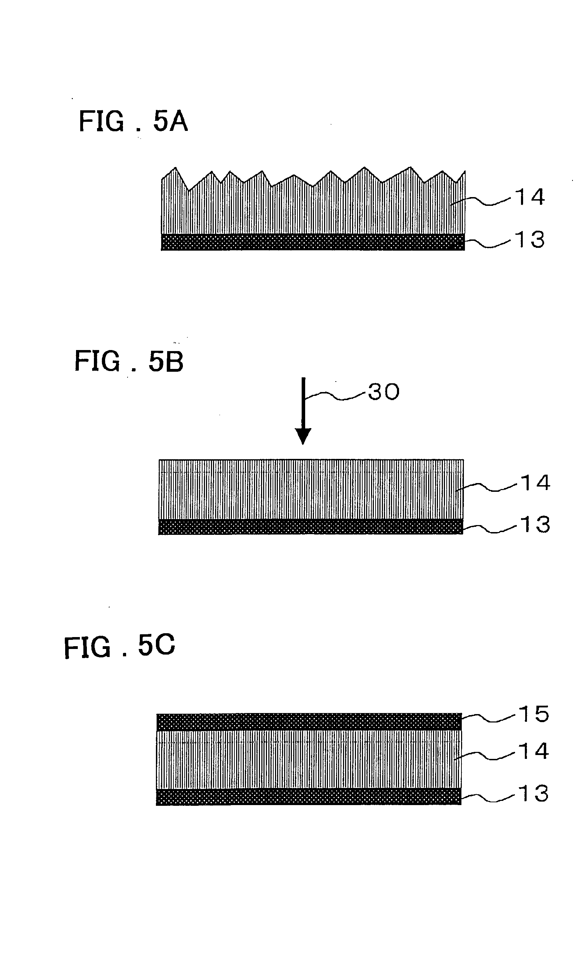

A preferred embodiment of the invention will now be described. A method for producing the semiconductor device, in accordance with an embodiment of the invention, includes, the following steps,
a first step: forming a lower electrode(13 in Fig.5A),
a second step: forming a polycrystalline dielectric thin film(14 in Fig.5A) having surface roughness on the lower electrode,
a third step: rapidly heating a surface layer portion of the dielectric thin film of a predetermined film thickness to melting and quenching(30 in Fig.5B) the portion to planarize the surface of the thin film, and
a fourth step: forming an upper electrode(15 in Fig.5C) on the dielectric thin film.

The dielectric thin film surface is planarized to prevent leak current and is made possible to demonstrate various characteristics proper to the dielectric material, such as a polarization hysteresis characteristic.

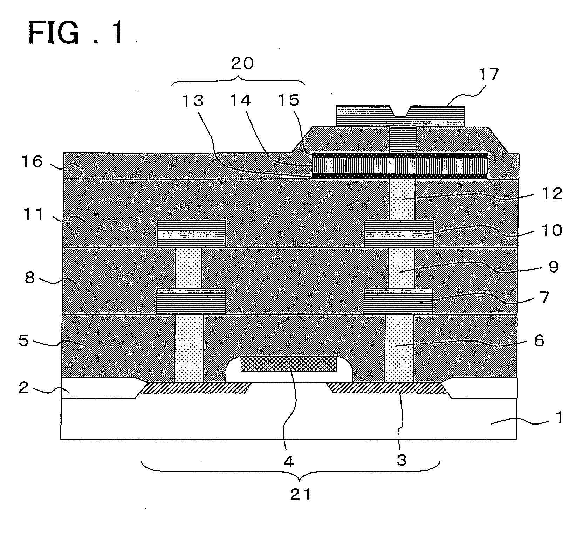

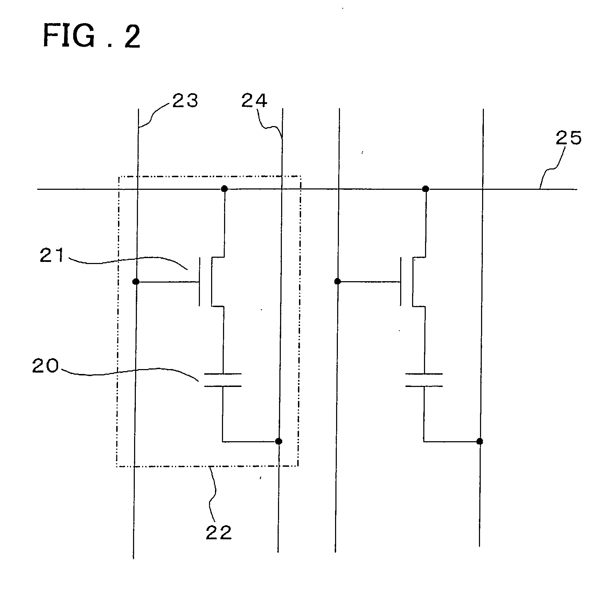

Referring to the drawings, certain preferred embodiments of the present invention will be explained more in detail. Fig. 1 is a partial schematic cross-sectional view of the structure of a semiconductor device according to a first embodiment of the present invention. Fig.2 is a partial circuit diagram of a semiconductor device according to the first embodiment of the present invention.

Referring to Fig. 2, a memory cell 22 includes a switching transistor 21 and a dielectric capacitor 20. A switching transistor 21 has a gate connected to a word line 23, while having one of a source and a drain connected to a bit line 25 and having the other of the source and the drain connected via a capacitor 20 to a plate line 24.

Referring to Figs. 1 and 2, this semiconductor device includes an MOS type switching transistor 21 on a silicon substrate 1, while including a dielectric capacitor 20 on the switching transistor 21 via inter-layer insulating films 5, 8 and 11.

A pair of first metal wirings 7, formed of a barrier metal, such as Ti, and an alloy mainly composed of Al and Cu, are selectively formed between the first inter-layer insulating film 5 and the second inter-layer insulating film 8. The first metal wirings 7 are electrically connected through a pair of plugs 6 to a diffusion layer 3 of the switching transistor. One of the first metal wirings 7 is used as a wiring interconnecting the dielectric capacitor 20 and the switching transistor 21, while the other first wiring 7 is used as a bit line 25 of Fig.2.

A pair of second metal wirings 10, formed of a barrier metal, such as Ti, and an alloy mainly composed of Al or Cu, are selectively formed between the second inter-layer insulating film 8 and the third inter-layer insulating film 11, and are electrically connected, through first vias 9, formed e.g., of tungsten, to the first metal wirings 7. One of the second metal wirings 10 is electrically connected through a second via 9 to a lower electrode 13. Thus, in the memory cell 22 of the first embodiment, there is formed a multi-layer metal wiring structure comprised of the first metal wirings 7 and the second metal wirings 10.

On the multi-layer metal wiring structure, there is provided a dielectric capacitor 20 through the third interlayer insulating film 11. The dielectric capacitor 20 is made up by the lower electrode 13, a thin dielectric film 14 and an upper electrode 15, in this order. The lower electrode 13 and the diffusion layer 3 are electrically interconnected through the plug 6, a first metal wiring 7, a first via 9, a second metal wiring 10 and a second via 12.

As the lower electrode 13 and the upper electrode 15, metals weaker in affinity with oxygen, such as Pt, Pd, Ir, Rh, Ir, Rh, Os, Au, Ag, Ru, and the like or electrically conductive oxide films such as PtOₓ, PdOₓ, IrOₓ, RhOₓ, OsOₓ, AuOₓ, AgOₓ, RuOₓ, and the like are used, in order to prevent deterioration of spontaneous polarization of a ferroelectric material due to oxygen deficiency. Although not shown, it is desirable to provide a barrier layer, formed of an electrically conductive nitride film, such as TiN, between the lower electrode 13 and the second via 12, in order to prevent inter-reaction and inter-diffusion between Pt of the lower electrode 13 and tungsten of the second via 12.

The dielectric thin film 14 is made up of a ferroelectric thin film such as BaTiO₃, PbTiO₃, PZT, PLZT, SBT and the like, or of a high-dielectric constant material, such as BST and the like.

On the dielectric capacitor 20 is formed a fourth inter-layer insulating film 16 and a third metal wiring 17 is selectively formed within and over a contact hole provided in the fourth inter-layer insulating film 16. A third metal wiring 17 is used as a plate wiring 24 in Fig.2.

That is, the structure of the memory cell 22 of the first embodiment lying below the lower electrode 13 is the same as the LSI not having a capacitor. Consequently, the structure can be prepared by a routine production process same as production process of a pre-existing logic circuit.

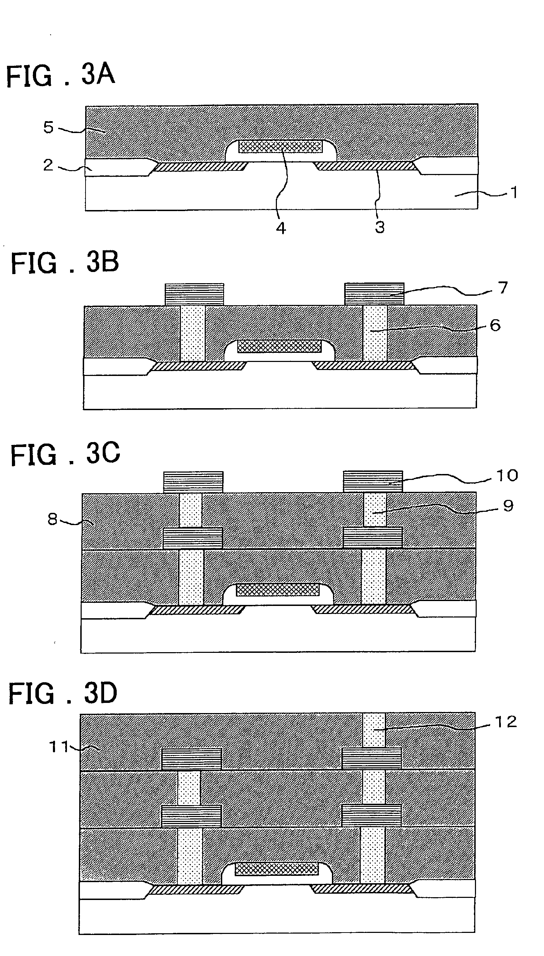

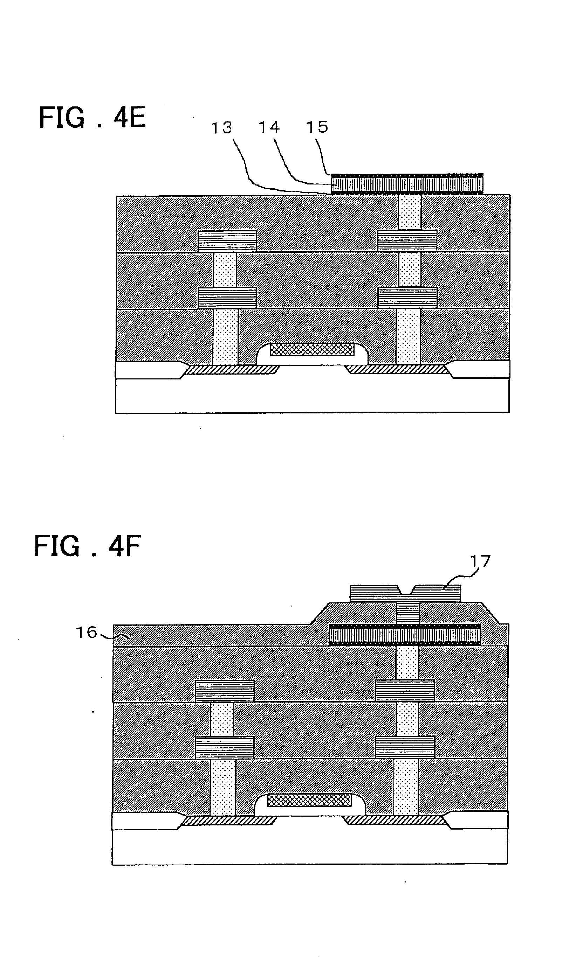

The process for manufacturing a semiconductor device of the first embodiment is now explained. Figs. 3A to 3E and Figs. 4E and 4F are cross-sectional views schematically showing the manufacture process of the semiconductor device according to the first embodiment of the present invention. Figs. 5A to 5C are cross-sectional views schematically showing the manufacture process of the dielectric capacitor according to the first embodiment of the present invention.

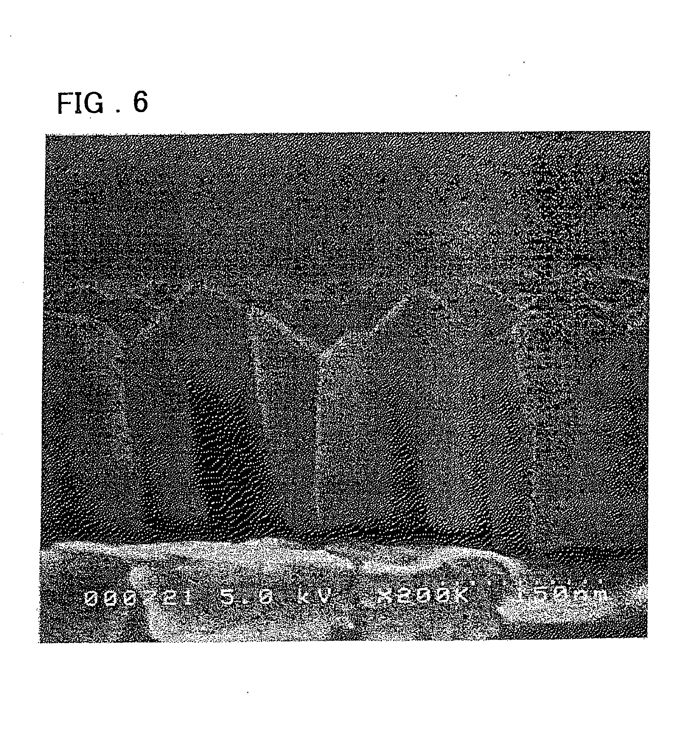

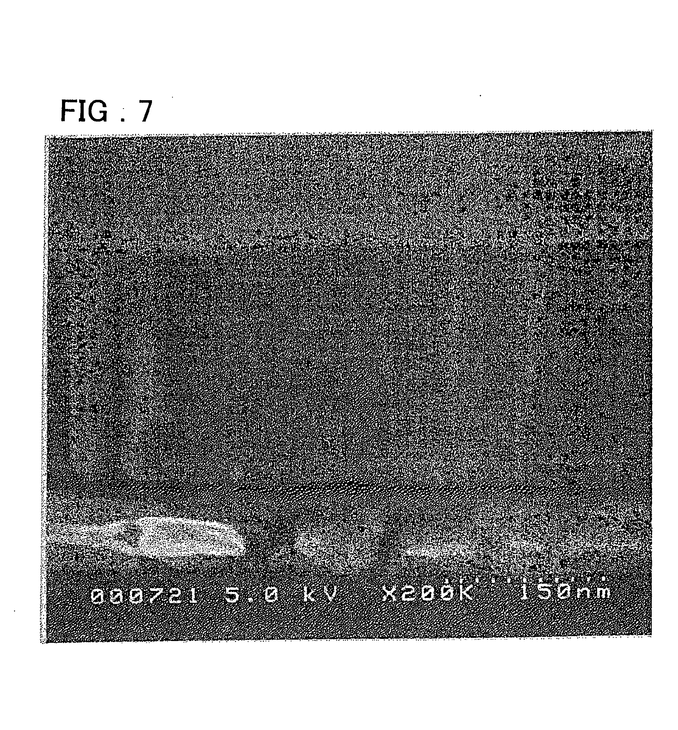

Fig.6 is a photo, taken by an electron microscope, of the cross-section of an as-formed dielectric thin film of a semiconductor device according to the first embodiment of the present invention, Fig. 7 is a photo, taken by an electron microscope, of the dielectric thin film of the semiconductor device of the first embodiment of the present invention, following laser irradiation,

First, an MOS transistor, such as a memory cell unit or a logic circuit unit, is formed on a silicon substrate 1, by a routine LSI manufacture process, as shown in Fig. 3A. That is, an oxide film 2 is selectively formed to delimit a device forming area by this oxide film 2. A gate electrode 4 and the diffusion layer 3 are then formed. The first inter-layer insulating film 5 then is formed on the silicon substrate 1. The so formed first inter-layer insulating film 5 is planarized by the CMP method or by a re-flow method.

The first metal wirings 7 and the plugs 6 interconnecting the first metal wirings 7 and the diffusion layers 3 then are formed.

As the forming method, there are a method consisting in forming the plugs 6 by tungsten plugs and subsequently depositing and processing the first metal wirings 7, and a dualdamasin method consisting in processing the first inter-layer insulating films 5 to the shape of the plugs 6 and the first metal wirings 7, burring a metal, then removing excess metal to form the plugs 6 and the first metal wirings 7 simultaneously.

In the former method, the plugs 6 are bored by etching, and the barrier metal, such as Ti or TiN, is then formed by contact injection and activation. Tungsten is then formed on the entire wafer surface by the CVD method. Then, surface tungsten is removed by the CMP method or an etch back to form tungsten plugs. The tungsten plugs my also be formed by selective growth of tungsten.

The first metal wirings 7 then are selectively formed on the plug

6, as shown in Fig. 3B. The first metal wirings 7 are formed by a composite layer, made up by a barrier metal, such as Ti or TiN, an alloy layer, mainly composed of Al or Cu, and an anti-reflection film of, for example, TiN, and are deposited as by a sputtering method or a CVD method followed by etching.

Then, as shown in Fig.3C, the second inter-layer insulating film 8 is formed and after planarization of the film 8, a pair of first vias 9 and second metal wirings 10 are then formed on the first metal wirings 7. The first vias 9 and the second metal wirings 10 are formed by a method similar to that for the plugs 6 and the first metal wirings 7.

A third inter-layer insulating film 11 then is formed, as shown in Fig.3D, and a second via 12 is formed e.g., with a tungsten plug on the second metal wirings 10, as in the case of the plug 6. At this time, surface tungsten is preferably removed by a CMP method. It is because the dielectric capacitor may then be subsequently formed on a completely planarized surface.

Annealing is then carried out in a hydrogen-containing atmosphere. The annealing temperature is preferably not lower than 300°C and not higher than 500°C. The reason is that the annealing temperature not higher than 300°C has only poor effect in improving transistor characteristics, while the annealing temperature not lower than 500°C tends to break the metal wirings 7, and 10.

The above-described processes are the same as the routine LSI processes not having the dielectric thin film capacity. No change in the process or addition of a particular process is made for connecting the dielectric thin film capacity to the diffusion layer 3.

A dielectric capacitor then is formed on the third inter-layer insulating film 11 for connection to the second via 12. The dielectric capacitor is formed by the following processes.

First, as shown in Fig. 4E, the lower electrode 13, formed of a noble metal, such as Pt, Ir, Ru or the like, or an electrically conductive oxide, such as IrO₂, RuO₂ or the like, is formed on the third inter-layer insulating film 11, by a sputtering method or the like.

In this case, a barrier film, formed of, for example, TiN, is formed below the layer of this noble metal or the electrically conductive oxide, in order to prevent inter-reaction and inter-diffusion between tungsten of the second via 12 and Pt of the lower electrode 13.

Then, the dielectric thin film 14 made up of such as Pb(Zr, Ti)O₃ (PZT), (Ba, Sr)TiO₃ (BST), SrTiO₃ (ST) or the like is formed on the lower electrode 13, by a CVD method or the like.

In forming the thin PZT film, heating at a temperature exceeding 600°C is required in order to obtain optimum PZT thin films by a routine sol/gel method or by a sputtering method. Such high temperature tends to cause breaking of the metal wiring or a high electrical resistance and hence is not applicable to the present structure. It is therefore desirable to perform film deposition at a lower temperature of the order of 450°C, as in the CVD method. The PZT thin film of a satisfactory crystal state, with the crystal grain size of the order of 50 nm or larger, may be formed by the CVD method in a temperature range of from 350°C to 500°C.

The ST thin film may be formed at 450°C by the ECR-CVD method, as discussed in, for example, International Electron Devices Meeting Technical Digest) 1994, pp.831.

Since the surface of the PZT film, obtained by the CVD method, presents roughness, the thickness of the PZT film from the bottom surface of the lower electrode to the apex of the maximum projection is preferably not less than 200 nm. That is, the sum of 50 nm which is the necessary smallest possible grain size of PZT, the depth of 100 nm affected by the energy of the XeCl excimer laser energy which acts on the PZT, and the maximum height of the surface roughness of 50 nm, is 200 nm.

The photo taken by an electron microscope of the cross-section of the PZT thin film is shown in Fig.6. The maximum height Rₘₐₓ according to JIS B 0601 (distance from the bottom of the maximum recess to the apex of the maximum projection of the surface roughness of the PZT thin film is not less than 50 nm, with the projection being of an edge shape. The PZT crystal grain is a columnar crystal with the aspect ratio not less than 2.5. The pronounced surface roughness is produced on crystal grain growth to not less than 50 nm sufficient to display the polarization hysteresis characteristic of PZT. If the upper electrode is formed as the PZT thin film surface presents this kind of surface roughness, the distance between the upper and lower electrodes is decreased in the recessed part so that electric field concentration tends to be produced to lower the insulating properties or to deteriorate a polarization inversion characteristic. For this reason, the planarization process of the surface of the dielectric thin film as described below is performed.

The surface of the dielectric thin film 14 is irradiated with an excimer laser 30. That is, the surface of the dielectric thin film 14 or its vicinity is rapidly heated to melting and subsequently quenched. This micro-crystallizes or amorphizes the surface of the thin film to a crystal grain size smaller than the crystal grain size of the lower layer where the laser action has not reached. Also, the thin film surface (surface layer portion) is planarized (see Fig.7). This is possibly ascribable to the phase transition or volumetric change in the crystal phase caused by the rapid change in temperature. Meanwhile, the excimer laser is such as ArF (λ = 126 nm), KrF excimer laser (λ = 248 nm) and XeCl excimer laser (λ = 308 nm).

If the XeCl excimer laser is used for irradiating the PZT thin film, the depth to which the energy reaches is meritoriously constant and is on the order of 100 nm from the surface. The result is that the surface layer portion in which the crystal is of the micro-crystal size or which has been amorphized may be formed to an approximately uniform film thickness. The energy density of the XeCl excimer laser where the surface of the PZT thin film 14 commences to be dissolved is 160 to 200 mJ/cm² as measured in atmosphere or under a reduced pressure. The photo of the cross-section of the PZT thin film, taken with an electron microscope, is shown in Fig.7, from which it may be seen that the film surface has been planarized to such an extent that the pre-irradiation surface shown in Fig.6 is only a poor comparison. On the other hand, the depth the energy reaches in the case of the KrF excimer laser is on the order of 50 m from the surface.

On the dielectric film surface 14, formed by the above-described method, the upper electrode 15 is formed by a method similar to the method as used for the lower electrode 13.

Then, the lower electrode 13, the dielectric thin film 14 and the upper electrode 15 are processed by etching. Thus the dielectric capacitor as shown in Fig.4E is completed.

A fourth inter-layer insulating film 16 is then formed on the third inter-layer insulating film 11 and on the dielectric capacitor and a contact hole then is formed in an upper portion of the capacitor. Then, as shown in Fig. 4(F), a third metal wiring 17, which serves as a plate line, is formed similarly to the first and second metal wirings 7 and 10.

The third metal wiring 17 is used only as the plate line 24, while it is not used in other logic circuits. Consequently, there is no device change in the logic circuit unit caused by forming a memory cell array unit employing the dielectric capacitor. On this third metal wiring, is formed a passivation film, not shown, formed of, for example, SiON.

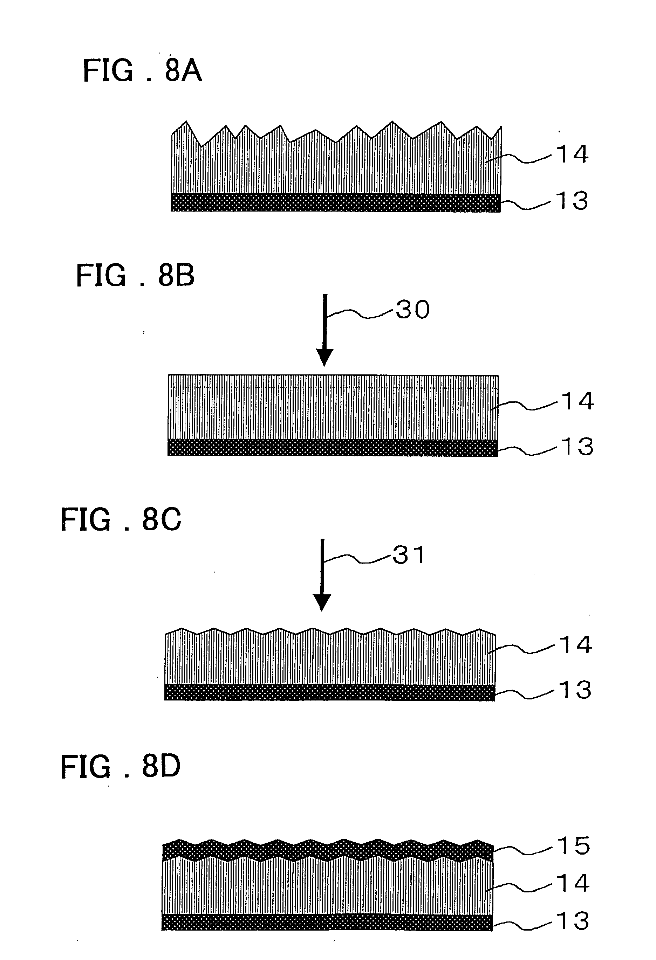

A second embodiment of the present invention is now explained with reference to the drawings. Figs. 8A to 8D are schematic cross-sectional views showing the method for producing a dielectric capacitor of a semiconductor device according to the second embodiment of the present invention.

Referring to Figs. 8A to 8D, if a PZT thin film 14 is formed by the CVD method on the lower electrode 13 as in the first embodiment, and an excimer laser 30 is applied on the surface of the PZT thin film 14 as in the first embodiment, the vicinity of the thin film affected by laser irradiation (to a depth of approximately 10 nm) is turned into a

polycrystalline or amorphous structure with only small crystal grain size. If the upper electrode 15 is formed on the so planarized PZT thin film 14, electric field concentration may be evaded with advantage, however, the polarization hysteresis characteristic, which should inherently be manifested, is slightly lowered, that is the amount of inverted electric charge is slightly decreased, by the action of the small-sized polycrystalline or amorphous area (area where ferroelectricity is hardly manifested). It is therefore desirable to remove the polycrystalline or amorphous PZT of small crystal grain size on the surface layer portion of the PZT thin film by high frequency (RF) plasma etching. As etching gases, HBr/Ar/CF₄ is used, with the flow velocity being 20/8/30 sccm, with the gas pressure being 0.532 Pa (4mTorr), an etching rate being 2 nm/sec. So, the thickness of approximately 50 nm is etched in 25 sec.

This makes the dielectric capacitor to demonstrate a polarization hysteresis characteristic proper to PZT. Although the PZT thin film surface may be slightly damaged by the etching, the maximum height of surface roughness of the thin film at this time is a few nm, thus being smaller than undulations on the thin film surface prior to the laser irradiation, which are approximately 70 nm, so that electric field concentration is advantageously less liable to occur than with a thin film not subjected to laser illumination. Although it may be contemplated to execute the etching prior to the laser irradiation, the dielectric thin film inherently has outstanding surface roughness such that it is not planarized significantly.

Following the etching, the upper electrode 15 may be formed on the PZT thin film, as in the first embodiment.

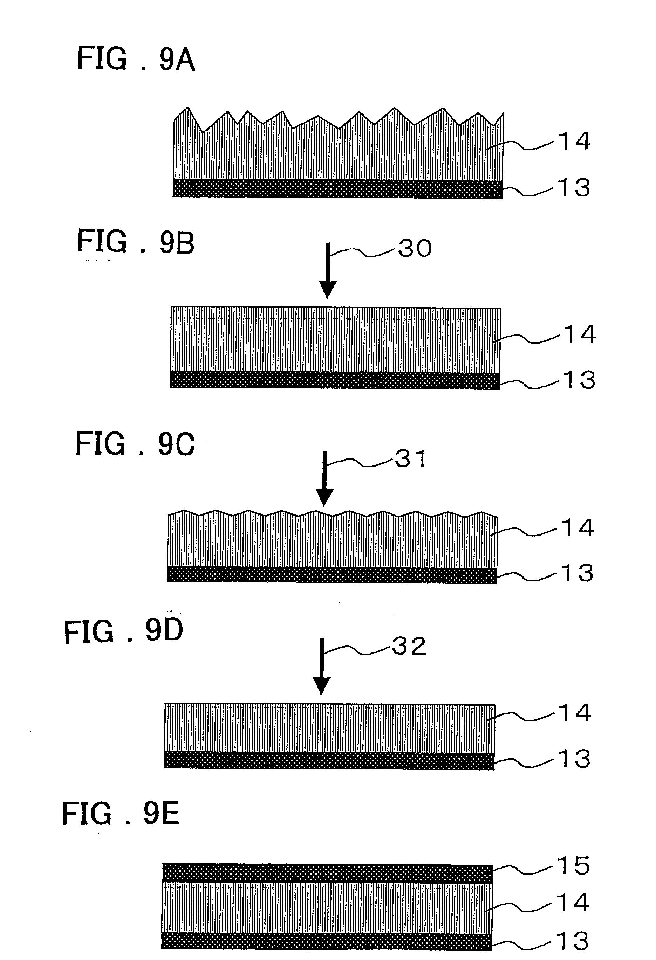

A third embodiment is now explained with reference to the drawings. Figs. 9A to 9E are schematic cross-sectional views showing a method for producing a dielectric capacitor of a semiconductor device of the third embodiment of the present invention.

Referring to Figs. 9A to 9E, if the PZT thin film 14 is formed on the lower electrode 13 by the CVD method, as indicated in the first embodiment, the surface of the PZT thin film 14 is irradiated with the excimer laser 30 as indicated in the first embodiment, and the polycrystalline to amorphous portion of the small crystal grain size on the surface layer portion of the PZT thin film 14 is plasma-etched 31, as indicated in the second embodiment, it may be an occurrence that the thin film surface is damaged to produce defects, which in turn may cause electric field concentration. It is therefore preferable to anneal the damaged portion by further irradiation of an excimer laser 32. This annealing eliminates defects present on the PZT thin film surface to provide a planarized surface to evade the electric field concentration.

This annealing micro-crystallizes or amorphizes the surface layer portion of the PZT thin film to lower a polarization hysteresis characteristic. However, since the size of the undulations (see Fig.9C) caused on the PZT film surface by the etching is smaller than the undulations (see Fig.9A) on the PZT thin film prior to the first irradiation of the excimer laser 30, it is possible to realize a film thickness smaller than the film thickness of the surface layer portion of the PZT thin film micro-crystallized or amorphized by the irradiation of the first excimer laser 30. It is therefore desirable to effect second irradiation of the second excimer laser 32 at an energy density (140 to 160 mJ/cm²) lower than the energy density (160 to 200 mJ/cm²) as used for the first excimer laser irradiation 30. The result is that the PZT thin film surface may be planarized, at the same time as the film thickness of the micro-crystallized or amorphized superficial portion may be suppressed to a thinner value, with the result that the electric field concentration may be evaded as the polarization hysteresis characteristic is prevented from being lowered.

After the planarization, it suffices to form the upper electrode 15 on the PZT thin film 14, in the same way as in the first embodiment.

The meritorious effects of the present invention are summarized as follows.

According to the present invention, a dielectric thin film, having a surface planarized, is produced, so that electric field concentration is prohibited to contribute to the miniaturization and high density of the memory cell.

Moreover, in the case of the ferroelectric thin film, optimum insulation properties and polarization inversion characteristic are obtained even if the film thickness is reduced. As a result, a ferroelectric capacitor capable of performing a low voltage operation can be produced. Although the main usage of this ferroelectric capacitor is the ferroelectric memory for low voltage operation, a low voltage operation (from 3V to 2.5V and thence to 1.8V) may be realized in other deices exploiting a ferromagnetic material.

It is because the electric field concentration may be eliminated by planarizing surface roughness innate to the polycrystalline film by laser processing.

Moreover, since the dielectric thin film is formed and surface processing is achieved at a lower temperature, it is possible to provide a high quality product not having damages in its metal layer.

It should be noted that other objects, features and aspects of the present invention will become apparent in the entire disclosure and that modifications may be done without departing the gist and scope of the present invention as disclosed herein and claimed as appended herewith.

Also it should be noted that any combination of the disclosed and/or claimed elements, matters and/or items might fall under the modifications aforementioned.

## Claims

1. A method for producing a semiconductor device having at least a dielectric capacitor, said method comprising:
a first step of forming a lower electrode;
a second step of forming a polycrystalline dielectric thin film on said lower electrode, said polycrystalline dielectric thin film having surface roughness;
a third step of heating rapidly a surface layer portion of said dielectric thin film of a predetermined film thickness to melting and quenching said portion to planarize the surface of said thin film; and
a fourth step of forming an upper electrode on said dielectric thin film.

2. The method for producing the semiconductor device as defined in claim 1, **characterized in that** the maximum height of surface roughness of the dielectric thin film formed by said second step is not less than 50 nm.

3. The method for producing the semiconductor device as defined in claim 1, **characterized in that** the thickness of the dielectric thin film formed by said second step as from a bottom surface facing towards the lower electrode to an apex of the maximum projection is not less than 200 nm.

4. The method for producing the semiconductor device as defined in claim 1, **characterized in that** an aspect ratio of a crystal grain of the dielectric thin film formed by said second step is not less than, 2.5.

5. A method for producing a semiconductor device having at least a dielectric capacitor, said method comprising:
a first step of forming a lower electrode;
a second step of forming, on said lower electrode, a polycrystalline dielectric thin film containing crystals of a preset grain size;
a third step of forming a processed film obtained on amorphizing or micro-crystallizing a surface layer portion of a preset film thickness of said dielectric thin film, in such a manner as to maintain the crystal grain size of a lower surface portion of said surface layer portion in said dielectric thin film at such a value as to retain a desired characteristic of the dielectric material; and
a fourth step of forming an upper electrode on said dielectric thin film.

6. The method for producing a semiconductor device as defined in claim 5, **characterized in that** the desired characteristic of said dielectric material is a polarization hysteresis characteristic.

7. The method for producing a semiconductor device as defined in any one of claims 1 to 6, **characterized in that** said method further comprises
a fifth step intermediate between said third and fourth steps, said fifth step being a step of etching said surface layer portion, rapidly heated and quenched, or amorphized or micro-crystallized, to a planar state.

8. The method for producing a semiconductor device as defined in claim 7, **characterized in that** said method further comprises
a sixth step intermediate between said fifth and fourth steps, said
sixth step being a step of annealing the surface layer portion of the as-etched dielectric thin film.

9. The method for producing a semiconductor device as defined in claim 7 or 8, **characterized in that** the planar surface of the polycrystalline dielectric thin film is exposed by said fifth step.

10. The method for producing a semiconductor device as defined in any one of claims 1 to 9, **characterized in that** the dielectric thin film in said fourth step includes at least a crystal of crystal grain size not less than 50 nm.

11. The method for producing a semiconductor device as defined in any one of claims 1 to 10, **characterized in that** the dielectric thin film in said second step is formed at a temperature not higher than 500°C by chemical vapor deposition.

12. The method for producing a semiconductor device as defined in any one of claims 1 to 11, **characterized in that** said third and sixth steps are carried out as an excimer laser is applied on said dielectric thin film surface.

13. The method for producing a semiconductor device as defined in claim 12, **characterized in that** the excimer laser is a XeCl excimer laser.

14. The method for producing a semiconductor device as defined in claim 12 or 13, **characterized in that** the energy density of the excimer laser in said sixth step is lower than that in said third step.

15. The method for producing a semiconductor device as defined in any one of claims 12 to 14, **characterized in that** the energy density of the excimer laser in said third step is 160 to 200 mJ/cm².

16. The method for producing a semiconductor device as defined in any one of claims 12 to 15, **characterized in that** the energy density of the excimer laser in said sixth step is 140 to 160 mJ/cm².

17. The method for producing a semiconductor device as defined in any one of claims 1 to 16, **characterized in that** said dielectric thin film formed in said second step is made up of a dielectric material of a perovskite crystal structure.

18. The method for producing a semiconductor device as defined in any one of claims 1 to 17, **characterized in that** said dielectric thin film formed in said second step is made up of a ferroelectric material or a high dielectric constant material.

19. The method for producing a semiconductor device as defined in any one of claims 7 to 18, **characterized in that** said etching is a plasma etching.

20. The method for producing a semiconductor device as defined in any one of claims 1 to 19, **characterized in that** said method further comprises a step of selectively forming at least a first layer metal wiring prior to forming said dielectric capacitor.

21. The method for producing a semiconductor device as defined in any one of claims 1 to 9, **characterized in that** in the second step, the surface roughness on crystal grain growth in of said polycrystalline dielectric thin film is of a value not less than a predetermined size sufficient to display a polarization hysteresis characteristic of said dielectric thin film.
